Europäisches Patentamt

**European Patent Office**

Office européen des brevets

(11) Publication number: **0 035 323**
**A1**

(12)
# EUROPEAN PATENT APPLICATION

(21) Application number: **81300419.9**

(22) Date of filing: **02.02.81**

(51) Int. Cl.³: **G 01 R 11/24,** G 01 R 11/04, G 08 B 13/00

(30) Priority: **01.03.80  GB 8007065**

(43) Date of publication of application: **09.09.81**
**Bulletin 81/36**

(84) Designated Contracting States: **AT BE CH DE FR GB IT LI NL SE**

(71) Applicant: **SANGAMO WESTON LIMITED, Great Cambridge Road, Enfield Middlesex EN1 3RX (GB)**

(72) Inventor: **Dorey, Howard Anthony, 15 Heathfield Close, Godalming, Surrey (GB)**

(74) Representative: **Stoole, Brian David et al, Schlumberger Measurement & Control (U.K.) Ltd. Victoria Road, Farnborough Hampshire GU14 7PW (GB)**

(54) **Electricity meters.**

(57)  An electricity meter for metering the amount of electrical energy supplied by a power supplier to a power consumer is provided with means for detecting unauthorised attempts to gain access to the interior of the meter. The detecting means typically comprises an optical path or an electrically conducting path which is arranged to be broken by such attempts. In one embodiment, the path is formed by a filamentary member used to seal a bolt holding on the meter case or cover, while in another embodiment, the path is broken by the removal of the meter cover or the terminal block cover. In either embodiment, a further path may be formed in or on the surface of the meter cover so as to be broken if the cover is broken or drilled.

ELECTRICITY METERS

This invention relates to electricity meters, eg. watthour meters, and is more particularly concerned with electricity meters incorporating means for detecting attempts at unauthorised access to the interior of the meter.

One common method of detecting attempts at unauthorised access to the interior of an electricity meter is to assemble the meter using bolts, for example to secure the meter cover (or case) to a meter base, and then to pass a wire through co·operating holes in the head of at least one of the bolts and a fixed part of the meter adjacent the head of that bolt and to seal the or each wire with a special seal, usually of lead.    The wired bolt  or bolts thus cannot be undone without breaking the or each . wire, which then cannot readily be re-sealed.

However, if the wire or wires are broken, this fact will not normally be detected until a meter-reader calls.   In some areas, the time interval between successive visits of a meter-reader can be up to one year, and it will be appreciated that the amount of electricity which can be stolen in such a time period is considerable.   Furthermore, if the or each wire is broken particularly carefully, the break or breaks may be very difficult to detect and therefore go unnoticed during at least the first visit.    It is an object of the present invention to alleviate this difficulty.

If the meter cover is broken, whether by accident or design, the meter is not only left with no security against unauthorised access and therefore tampering, so that its reading becomes suspect, but may also be dangerous.    It is a further object of the present invention, in some of its preferred embodiments, to alleviate this problem.

According to the present invention, there is provided an electricity meter for measuring the amount of electricity supplied by an electrical power supplier to an electrical power consumer via an electrical power distribution circuit, the meter comprising:

at least one part which must be moved relative to the remainder of the meter to permit access to the interior of the meter;

the meter being characterised by tamper detection means for detecting relative movement of said part with respect to the remainder of the meter and for producing an electrical signal indicative of such relative movement, and means responsive to said signal to effect at least one of the following operations:

(a)    to discontinue the supply of electricity to the consumer;

(b)    to transmit a corresponding signal to the supplier;

(c)    to operate an alarm associated with the meter; and

(d)    to increase the indication of, or the rate of increase of the indication of, the amount of electricity supplied to the consumer.

The invention will now be described, by way of example only, with reference to the accompanying drawings, of which:

0035323

Figure 1 is a somewhat schematic illustration of part of a first embodiment of an electricity meter in accordance with the present invention;

Figure 2 is a schematic illustration of part of a second embodiment of an electricity meter in accordance with the present invention;    and

Figures 3 and 4 are schematic illustrations of meter cases for use with either of the meters of Figures 1 and 2.

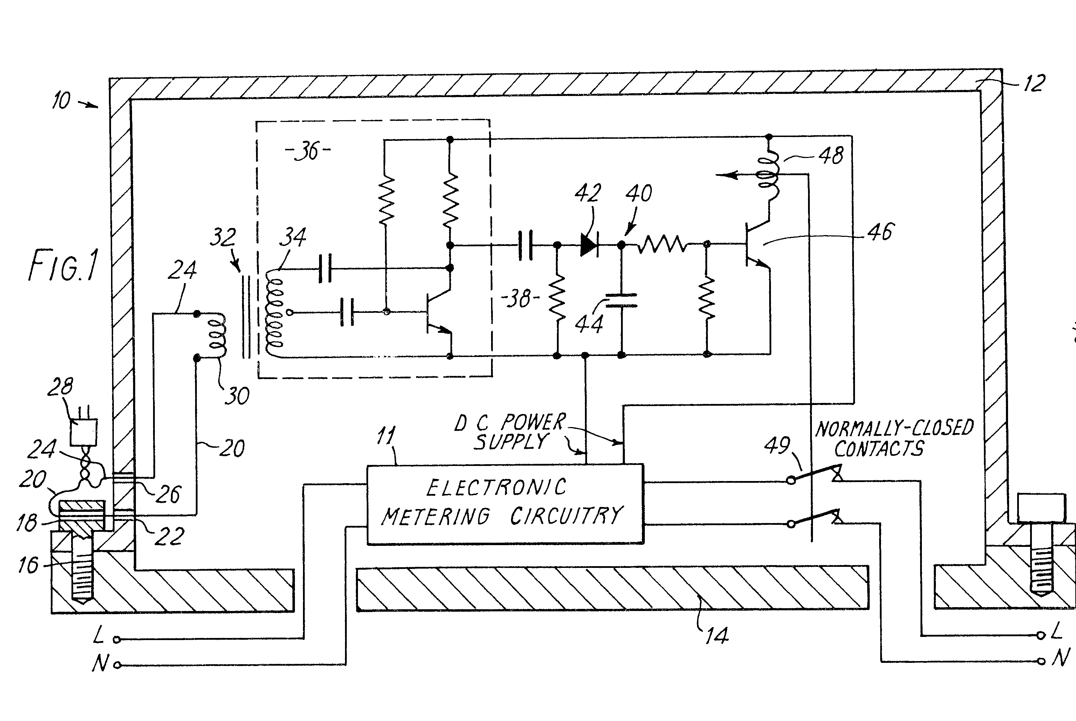

The electricity meter shown in Figure 1 is indicated generally at 10, and is shown  connected in a domestic electrical power distribution circuit consisting of a live wire L and a neutral wire N having a typical voltage of 220 to 240 volts AC, at 50 Hz, therebetween.   The electrical power supplier's power generation installation will be assumed to be connected to the left hand ends of the wires L and N, as viewed in Figure 1, while the electrical power consumer's installation will be assumed to be connected to the right hand ends of the wires L and N.   The meter 10 includes electronic circuitry 11 and its associated DC power supplies (not shown), preferably of the kind described and claimed in co·pending United Kingdom Patent Application No. 20564/77, for measuring the amount of electrical energy supplied to the consumer via the meter.

The meter 10 also comprises a main cover or case 12, within which the aforementioned electronic circuitry is contained, this case being secured to a base plate 14 by means of at least one bolt 16.   The bolt 16 has a hole 18 in its head, and a wire 20, coming from the interior of the case 12 via a hole 22 therein, is  passed through the hole 18 and then twisted together with another wire 24 which extends back into the interior of the case 12 via another hole 26.   The twisted-together wires 20 and 24 are then sealed together by means of a conventional lead seal 28.

The process of sealing the bolt 16 with the twisted-together and sealed wires 20 and 24 is carried out upon installation of the meter 10 in the consumer's premises.   It will be appreciated that the bolt cannot thereafter be undone without breaking one of the wires 20 and 24.

The respective ends of the wires 20 and 24 in the interior of the case 12 are respectively connected to the opposite ends of the secondary winding 30 of an isolating transformer 32, whose primary winding 34 forms part of the tank circuit of a low voltage transistorised Colpitts oscillator 36.  Thus as long as the wires 20 and 24 are connected together, the secondary winding 30 of the transformer 32 is short-circuited and the oscillator 36 is prevented from operating.  However, as soon as the connection between the wires 20 and 24 is broken, eg by an unauthorised attempt to undo the bolt 16, the oscillator 36 commences to operate normally and produces an A.C. output signal, having a typical frequency of 50 kHz.  This AC signal is applied, by means of a differentiating circuit 38, to a peak-detector circuit 40 comprising a diode 42 and a capacitor 44. The output signal produced by the peak-detector circuit 40 turns on a power transistor 46, which in turn operates a latching relay 48 having respective contacts 49 connected in series with both of the wires L and N. The latching relay 48 thus disconnects the consumer's supply of power.

The power transistor 46 also triggers a warning signal generator 50, which applies a suitable warning signal to a signal transmitter (not shown) of the kind described and claimed in our co-pending UK Patent Application No. 8005454, for transmission to the power supplier over the power distribution circuit.

The latching relay 48 is preferably sealed and arranged so that it cannot readily be reset by the consumer:  for example,  it may be designed so that a special tool is required to reset it.   Accordingly, if the consumer has broken the connection between the wires 20,24, whether accidentally or deliberately, it will normally  be necessary for him to ask the power supplier to send a meter engineer to reset the latching relay and thus restore the supply of power.

However, if the consumer attempts to reset the latching relay 48 himself, or to by·pass it, then the power supplier will in any case have already received the aforementioned warning signal.   The power supplier can therefore send a meter inspector to inspect the meter 10 at any convenient time.   Additionally, the meter 10 can also incorporate at least some of the anti-theft features described in our co·pending United Kingdom Patent Application No. 8004198.   In this case, the latching relay 48 would in practice be constituted by the circuit breaker 44 of that application, and means, substantially as described in relation to Figure 1B of that application, would be provided to sense the presence of the supply voltage down-circuit of the circuit-breaker latching relay after operation thereof and to increase the indications of the meter in response to such presence.

The Colpitts oscillator 36 and the power transistor 46 derive the DC power supply necessary for their operation from the DC power supplies of the aforementioned electronic circuitry.   It will be appreciated that a relatively low DC voltage is involved, and this, and more particularly the use of the isolating transformer 32, ensure that the sealed wires 20 and 24 remain intrinsically safe, even though  they are electrically connected to the interior of the meter 10.

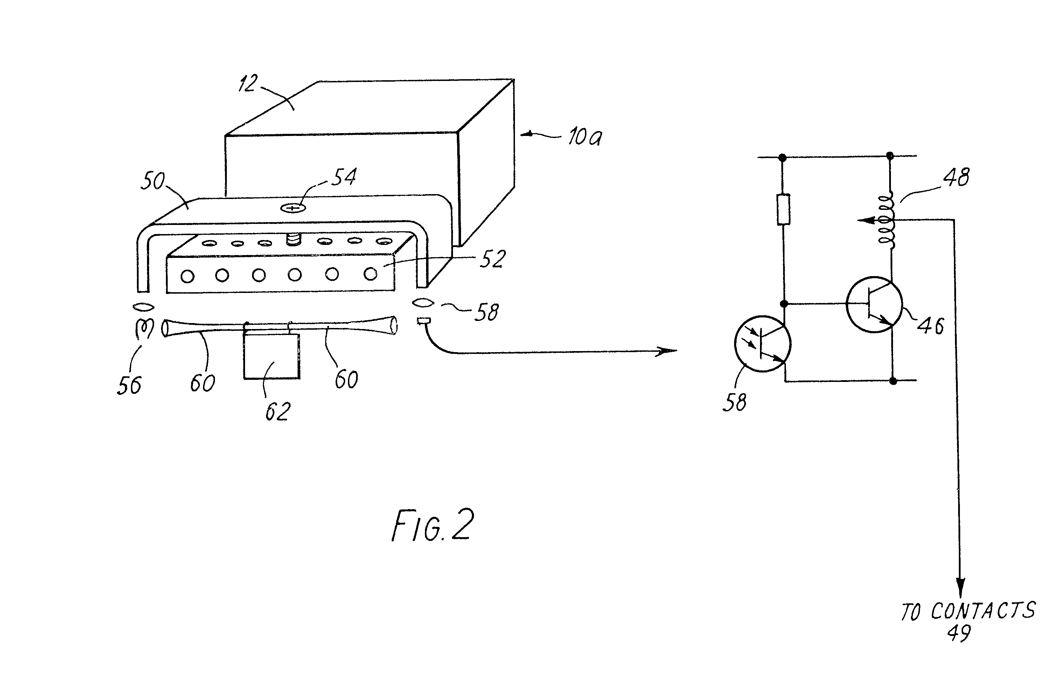

Several modifications can be made to the meter 10.   For example, the wires 20 and 24 can be replaced by a fibre optic which extends from a light (or infra red) source such as a light-emitting diode inside the case 12, through the hole 18 in the head of the bolt 16, and is then plugged back into a suitable socket in the case to direct light (or infra red radiation)  from the source onto a suitable detector, such as a phototransistor, inside the case:  the detector is arranged to turn on the power transistor 46 if it ceases receiving light (or infra red radiation) from the source, with the consequences described above. In this case, means is providing for inhibiting the operation of the detector (and/or the power transistor 46) during installation of the meter, ie until after the fibre optic has been passed through the hole 18 in the head of the bolt 16 and then plugged back into the meter, which means can be substantially as described hereinafter with reference to Figure 2.

To reduce the possibility of accidental breakage of the wires 20,24 or of the fibre optic, the meter can be provided with a simple protective cover which fits over the head of the bolt 16 to protect them.

The meter of Figure 2 is indicated generally at 10a, and has various elements in common with the meter 10 of Figure 1: these elements accordingly bear the same elements as were used in Figure 1, and only the points of difference will be described.

Thus the meter 10a includes an auxiliary cover 50, which may typically fit over the main terminal block 52 of the meter and which is held in position either by a fixing bolt 54 requiring a special Allen key to undo it, or by conventional wire-and-lead-sealed bolts of the kind mentioned in the introduction to this specification. The cover 50 incorporates an optically transparent material, which may for example comprise a light guide embedded in the cover or bonded to its inside surface. This material forms an optical path between a light source 56, such as a light-emitting diode, and a light detector 58, such as a phototransistor, only as long as the cover 50 is correctly positioned over the terminal block 52. Thus as soon as the cover 50 is removed from the meter, the detector 58 turns on the power transistor 46, with the consequences described earlier in relation to Figure 1.

To allow the meter 10a to be assembled and installed, a separate light path constituted by a fibre optic 60 is arranged between the source 56 and the detector 58. The fibre optic 60 is fastened to a tag 62, which is engraved for example with the serial number of the meter 10a, and which is accessible from outside the meter (for example, the fibre optic 60 may pass through respective small holes from the inside of the meter to the outside and back in again, with the tag being fastened to the portion of the fibre optic outside the meter). When installation is complete, the fibre optic 60 is simply removed (or broken) by pulling on the tag 62, which is then returned to the power supplier by the installation engineer as evidence of correct installation.

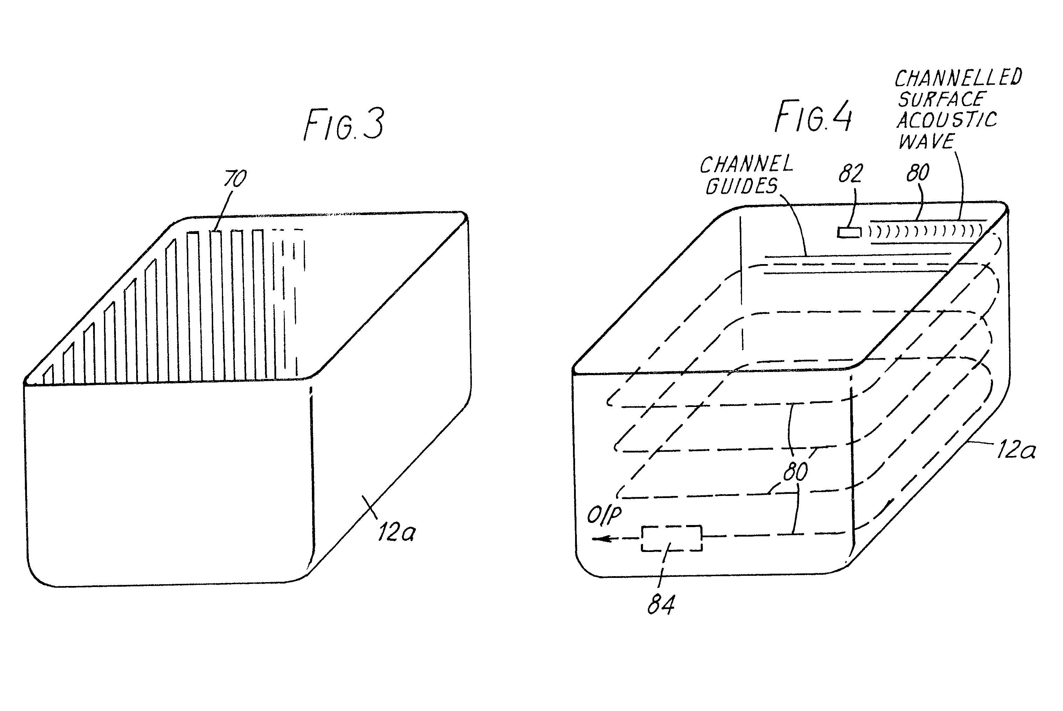

Figure 3 shows, at 12a, a specific embodiment of the case 12 of Figures 1 and 2.     Thus the case 12a has a sinuous or meandering electrically conductive path 70 formed over substantially the whole of its internal surface.     This path is connected to, and checked for electrical continuity by, a circuit substantially identical to that of Figure 1, viz a circuit comprising an isolating transformer, a Colpitts oscillator, a differentiating circuit and a peak-detector circuit, this peak-detector circuit incorporating the same capacitor 44 as the peak-detector circuit 40, or the output of this peak-detector circuit being combined with that of the peak-detector circuit 40 in an OR gate (not shown).

If the case 12a is broken, or if a hole is drilled in it, it is extremely likely that the conductive path 70 will be broken, with the consequences already described in relation to Figure 1.     This has obvious safety advantages when, for example, the case 12a is broken accidentally.

The case 12a is preferably made of a type of plastic which tends to shatter if drilled or sawn.

The meandering conductive path 70 embedded in the case 12a if desired, can be replaced by a fibre optic bonded to the inside of the case:   in the latter case, the circuit of Figure 2 is used to detect breakage of the fibre optic.

Alternatively, and as shown in Figure 4, the path 70 of Figure 3 could be replaced by a sinuous or meandering channel 80 adapted for the transmission of acoustic waves, typically surface acoustic waves at an ultrasonic frequency, from a surface acoustic wave (SAW) transmitter 82 to a suitable SAW receiver 84:   solid state SAW transmitters and receivers suitable for such use are now becoming relatively inexpensive.     Breaking or drilling the case 12a of Figure 4 interrupts the channel 80, thus affecting the transmission of the acoustic waves to the receiver 84.     The output of the receiver 84 is arranged to turn on the power transistor 46 of Figure 1, with the consequences described hereinbefore in relation to Figure 1.

Many other modifications can be made to the described embodiments of the invention.    For example, in those embodiments employing a light source and a light detector, the light source may with advantage be modulated (or pulsed) to ensure that the light therefrom can readily be distinguished from daylight.    Further, in embodiments such as that described with reference to Figure 2, where means including a light detector are provided for  detecting removal of the (or a) cover, the light source may be omitted: in this case, the light detector is arranged to be in total darkness as long as the cover is in its correct position, but to be exposed to daylight as soon as the cover is removed.    Alternatively, the cover may be arranged to form part of a capacitance whose change in value upon removal of the cover is sensed.

Moreover, in those embodiments employing a wire or other electrically conductive path whose breakage is sensed, the circuit for detecting the change in resistance between the ends of the path upon breakage thereof need not be a Colpitts oscillator, but can be any other convenient circuit, such as a voltage-or current-level detector arranged to sense a voltage or current which is changed by breakage of the path.    Where it is desired to form such a path on glass forming part of the case, a very thin tin oxide layer can be used.

For meters which include more than one cover or case, each cover or case can be protected, both against unauthorised removal and against breakage or drilling.    Further, it is possible to provide more than one stage of protection.    For example, unauthorised removal of a first cover can be arranged to operate a warning, such as a siren or flashing light, whose operation can be stopped by the consumer, eg by replacing the first cover.    Removal of the first cover also reveals a second cover, which bears a warning notice that its removal will cut-off the consumer's supply of electricity supply and/or increase the meter indication of, or the rate of increase of the meter indication of, the amount of electrical energy supplied to the consumer.

Finally, the bolt 16 can be arranged, when fully screwed in, to hold a switch such as a microswitch open or closed, so that unscrewing the bolt changes the state of the switch and thus operates the latching relay:  the or each cover can similarly co-operate with such a switch.

CLAIMS

1. An electricity meter for measuring the amount of electricity supplied by an electrical power supplier to an electrical power consumer via an electrical power distribution circuit, the meter comprising:

at least one part which must be moved relative to the remainder of the meter to permit access to the interior of the meter;

the meter being characterised by tamper detection means for detecting relative movement of said part with respect to the remainder of the meter and for producing an electrical signal indicative of such relative movement, and means responsive to said signal to effect at least one of the following operations:

    (a)   to discontinue the supply of electricity to the consumer;

    (b)   to transmit a corresponding signal to the supplier;

    (c)   to operate an alarm associated with the meter; and

    (d)   to increase the indication of, or the rate of increase of the indication of, the amount of electricity supplied to the consumer.

2. A meter as claimed in claim 1, characterised in that the detection means includes means for defining a radiant energy path which is either broken or completed in response to such relative movement.

3. A meter as claimed in claim 2, further characterised by a radiant energy source for directing radiant energy into said path, a radiant energy detector for receiving radiant energy from the source via said path and means for sensing the change in the radiant energy received upon breakage or completion of said path.

4. A meter as claimed in claim 2 or claim 3, characterised in that the radiant energy is acoustic energy.

5. A meter as claimed in claim 2 or claim 3, characterised in that the radiant energy is electromagnetic energy.

6. A meter as claimed in claim 5, characterised in that the electromagnetic energy is visible or infra red light.

7. A meter as claimed in claim 6, characterised in that said path includes a fibre optic arranged to be broken intermediate its ends by such relative movement.

8. A meter as claimed in claim 1, characterised in that the detection means includes an electrically conductive path which is either broken or completed in response to such relative movement.

9. A meter as claimed in claim 8, characterised in that the path comprises a switch.

10. A meter as claimed in claim 8, characterised in that the path includes a wire arranged to be broken intermediate its ends by such relative movement, and the detection means comprises circuit means coupled to the ends of the wire for sensing the change in resistance between said ends due to such breakage.

11. A meter as claimed in any preceding claim, further comprising at least one removable cover, characterised in that the cover itself serves as said movable part, removal of the cover constituting such relative movement.

12. A meter as claimed in any one of claims 1 to 10, further comprising at least one cover and at least one bolt for securing the cover to the rest of the meter, characterised in that the bolt also serves as said movable part, rotation of the bolt constituting such relative movement.

13. A meter as claimed in claim 11 or claim 12, wherein a substantial portion of the cover has an electrically or acoustically conductive path within it or on its surface, the path being so arranged that breakage of said portion of the cover, or drilling a hole in said portion, breaks said path, breakage of said path also being arranged to effect at least one of said operations.

14. A meter as claimed in any preceding claim, further characterised by means for inhibiting the operation of at least one of the detection means and the means responsive to the detection means during installation of the meter.

15. A meter as claimed in claim 14, characterised in that the inhibiting means includes a timing circuit arranged to inhibit such operation for a sufficient amount of time to permit installation to be completed.

16. A meter as claimed in claim 14, characterised in that the inhibiting means comprises means removable from the meter after installation.

17. A meter as claimed in claim 14, characterised in that the inhibiting means comprises means whose inhibiting action can be cancelled from outside the meter after installation.

FIG.1

ELECTRONIC METERING CIRCUITRY

D C POWER SUPPLY

NORMALLY-CLOSED CONTACTS

1/3

0035323

FIG.2

TO CONTACTS
49

FIG.3

FIG.4

70

12a

CHANNELLED
SURFACE
ACOUSTIC
WAVE

CHANNEL
GUIDES

82    80

80

12a

O/P

84

3/3

0035323

## DOCUMENTS CONSIDERED TO·BE RELEVANT

| Category | Citation of document with indication, where appropriate, of relevant passages | Relevant to claim |
|---|---|---|
| P | EP – A1 – 0 014 517 (SOUTH EASTERN ELECTRICITY BOARD) <br> * claim 15 * | 1 |
| | AT – B – 98 870 (J. MILETICH) <br> * page 1, lines 1 to 37 * | 1,11 |
| A | DE – A1 – 2 840 966 (R.L. DAVIDSON) <br> * claims 1, 2 * | 2,3,5, 6,7 |
| A | FR – A1 – 2 418 504 (CGEE ALSTHOM) <br> * claims 1 to 5 * | 2,3,5, 6,7 |
| A | US – A – 3 854 792 (A.R. KOELLE) <br> * abstract * | 2,13 |
| A | DE – B2 – 2 603 593 (AMERICAN DISTRICT TELEGRAPH) <br> * column 3, lines 29 to 42; <br> column 4, lines 52 to 65 * | 4 |
| A | DE – A –2 232 833 (SALIENT ELECTRONICS) <br> * claim 1 * | 8 |

./..

**CLASSIFICATION OF THE APPLICATION (Int. Cl.³)**

G 01 R   11/24
G 01 R   11/04
G 08 B   13/00

**TECHNICAL FIELDS SEARCHED (Int. Cl.³)**

G 01 R   11/00
G 01 R   11/04
G 01 R   11/24
G 01 R   21/00
G 02 B   5/14
G 02 B   5/16
G 08 B   13/00
G 08 B   13/04
G 08 B   13/06

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| Berlin | 03-06-1981 | LEMMERICH |

EPO Form 1503.1   06.78

0035323
Application number

European Patent Office

EUROPEAN SEARCH REPORT

EP 81 30 0419.9

– page 2 –

## DOCUMENTS CONSIDERED TO BE RELEVANT

| Category | Citation of document with indication, where appropriate, of relevant passages | Relevant to claim |
|---|---|---|
| A | US – A – 3 014 207 (C. PRINCIPALE) <br> * column 3, line 55 to column 4, line 7; fig. 2 * <br> -- | 10 |
| A | US – A – 4 092 641 (T.A. BELLINGHAUSEN et al.) <br> * column 1, lines 40 to 68 * <br> ----- | |

### CLASSIFICATION OF THE APPLICATION (Int. Cl.³)

### TECHNICAL FIELDS SEARCHED (Int. Cl.³)

G 08 B   13/08

G 08 B   13/12

G 08 B   13/14

G 08 B   13/16

G 08 B   13/18

G 08 B   13/22

EPO Form 1503.2   06.78